# EUROPÄISCHE PATENTSCHRIFT

(11) **EP 2 724 436 B1**
(45) Veröffentlichungstag und Bekanntmachung des Hinweises auf die Patenterteilung: **23.08.2017**
(21) Anmeldenummer: 12730383.2
(22) Anmeldetag: 21.06.2012
(51) Int. Cl.: H02H 3/04, H03K 17/18, H01R 31/00, H01T 1/12, G06K 19/07

(54) **ZUSTANDSKONTROLL- ODER DIAGNOSESYSTEM**
STATE MONITORING OR DIAGNOSTICS SYSTEM
SYSTÈME DE DIAGNOSTIC OU DE CONTRÔLE D'ACCÈS

(30) Priorität: 21.06.2011 DE 102011110252
(43) Veröffentlichungstag der Anmeldung: 30.04.2014
(73) Patentinhaber: Phoenix Contact GmbH & Co. KG, 32825 Blomberg (DE)
(72) Erfinder: BENT, Roland, 32758 Detmold (DE); KALHOFF, Johannes, 32825 Blomberg (DE)
(74) Vertreter: Blumbach Zinngrebe
(86) Internationale Anmeldenummer: PCT/EP2012/002618
(87) Internationale Veröffentlichungsnummer: WO 2012/175206

(56) Entgegenhaltungen:
- EP-A1- 1 172 638
- DE-A1- 10 248 640
- US-A- 5 680 106
- US-A1- 2002 021 226

## Beschreibung

### Gebiet der Erfindung

Die Erfindung betrifft ein Zustandskontroll- oder Diagnosesystem sowie ein Verfahren zur Zustandskontrolle oder Diagnose von Geräten, insbesondere für Überspannungsschutzschutzgeräte sowie ein System und Verfahren zum Übertragen von Messwerten.

### Hintergrund der Erfindung

Überspannungen sind potentielle Störfaktoren, die Schäden oder Zerstörungen in elektrischen Geräten verursachen können. Daher werden in vielen Bereichen der Elektrotechnik, z.B. in der Stromversorgungstechnik, der Mess-, Steuerungs- und Regelungstechnik, der Informationstechnik und für Sende- und Empfangsanlagen Überspannungsschutzgeräte eingesetzt. Beispiele hierzu finden sich z.B. unter www.phoenixcontact.de/ueberspannungsschutz.

Überspannungsschutzgeräte sind zwar dafür ausgelegt, hohen Stoßstrombelastungen Stand zu halten. Dennoch können energiereiche Überspannungs-Einkopplungen die Schutzgeräte überlasten. Wenn ein Überspannungspuls auftritt, kann es vorkommen, dass dieser zwar ordnungsgemäß von dem Überspannungsschutzgerät abgeleitet wird, das Überspannungsschutzgerät aber selbst einen Schaden davonträgt. Dann funktioniert das Überspannungsschutzgerät möglicherweise beim nächsten Auftreten einer Überspannung nicht mehr ordnungsgemäß und dann könnte ein Schaden an der elektrischen Anlage auftreten, welcher gerade durch das Überspannungsschutzgerät vermieden werden soll. Damit die Überspannungsschutz-Maßnahme immer wirksam ist, werden daher die Überspannungsableiter gelegentlich überprüft. Hierzu werden die, häufig als Wechselmodule ausgestaltete, Überspannungsschutzgeräte vom Nutzer aus der Anlage entfernt und in ein Prüfgerät eingesetzt, um dort geprüft zu werden.

Aus der DE 10 2004 006 987 B3 ist ferner bekannt, RFID-Transponder zur Zustandskontrolle und Protokollierung von Überspannungsschutz-Geräten zu verwenden, um eine Fernabfrage zu ermöglichen. Dabei wird eine bekannte Fehlererkennungseinheit verwendet, welche über einen RFID-Transponder ausgelesen und abgefragt wird. Im Fehlerfall des Überspannungsschutzgeräts wird die Fehlererkennungseinheit veranlasst, den Transponder-Antennenkreis kurzzuschließen, zu unterbrechen oder die Schwingkreisfrequenz des Transponder-Antennenkreises zu verändern.

Die Verwendung von RFID-Transpondern, insbesondere in Überspannungsschutzgeräten birgt allerdings die Gefahr, dass gerade die RFID-Transponder von einem elektromagnetischen Puls zerstört werden können. Problematisch bei dem in DE 10 2004 006 987 beschriebenen Verfahren ist dabei, dass unter Umständen nicht unterschieden werden kann, ob der RFID-Transponder zerstört ist oder die Fehlererkennungseinheit angesprochen hat. Möglicherweise wird nämlich der RFID-Transponder zerstört und das Überspannungsschutzgerät selbst ist aber noch funktionsfähig. Das kann zu einem unnötigen und kostenträchtigen Austausch führen. Ferner haben RFID-Transponder eine geringe elektromagnetische Verträglichkeit (EMV), was besonders für die genannten Anwendungen problematisch ist. Im Übrigen ist die Verwendung von RFID-Transpondern aufwändig und kostenträchtig, was deren Einsatz auf komplexere Gerätschaften beschränkt.

Das Dokument US 2002/0021226 A1, das den Oberbegriff der unabhängigen Vorrichtungsansprüche bildet, zeigt einen elektrischen Apparat, welcher elektromagnetische Strahlung aussendet und ein Empfangssignal erhalten kann.

Aus der DE 102 48 640 A1 geht ein Schaltgerät zur Signalübertragung zwischen diesem und einer Signalverarbeitungseinheit hervor.

### Allgemeine Beschreibung der Erfindung

Die Erfindung hat sich daher die Aufgabe gestellt, ein Zustandskontroll- oder Diagnosesystem bzw. ein Verfahren zur Zustandskontrolle oder Diagnose von Geräten bereit zu stellen, welches einfach aufgebaut und kostengünstig ist.

Eine weitere Aufgabe der Erfindung ist es, ein Zustandskontroll- oder Diagnosesystem bzw. ein Verfahren zur Zustandskontrolle oder Diagnose von Geräten bereit zu stellen, welches eine hohe elektromagnetische Verträglichkeit aufweist und unempfindlich, insbesondere gegen Überspannungen und elektromagnetische Pulse (sog. EMP), insbesondere gegen elektromagnetische Pulse eines Blitzschlags (sog. LEMP) ist.

Eine weitere Aufgabe der Erfindung ist es, ein Verfahren zur Übertragung von Messwerten bereit zu stellen, welches ohne eigene elektrische Versorgung auskommt und äußert einfach und kostengünstig ist.

Die Aufgabe der Erfindung wird durch den Gegenstand der unabhängigen Ansprüche gelöst. Vorteilhafte Ausführungsformen der Erfindung sind in den Unteransprüchen definiert.

Der Grundgedanke der Erfindung besteht darin, dass Information von der Resonanzfrequenz eines Resonatorschaltkreises repräsentiert wird und durch elektromagnetische Anregung des Resonatorschaltkreises und Messung der Resonanzfrequenz anhand der Signalantwort ausgelesen wird. Die Signalantwort ist die (abklingende) elektromagnetische Resonanzschwingung des Resonatorschaltkreises.

Gemäß einem ersten Aspekt der Erfindung wird ein Zustandskontroll- oder Diagnosesystem für Geräte, insbesondere elektronische und elektromechanische Geräte bereit gestellt. Jedes der Geräte umfasst einen Funktionsbaustein, welcher in dem Gehäuse des Gerätes untergebracht ist. Dieser Funktionsbaustein kann z.B. ein Überspannungsschutzbaustein sein und soll mit der Erfindung überwacht werden, wobei die Erfindung in ihrer allgemeinen Form aber nicht auf die Überwachung von Überspannungsschutzbausteinen beschränkt ist.

Das Gerät umfasst ferner eine Überwachungs- und Übertragungseinrichtung, welche den Funktionsbaustein in dem Gerät überwacht und eine Information über den momentanen Zustand des Funktionsbaustein übertragen kann. Die Information über den Zustand kann im einfachsten Fall lediglich die binäre Information sein, nämlich dass der Funktionsbaustein entweder noch funktionsfähig ist oder dass er möglicherweise beschädigt ist. Das Abfragen der Information erfolgt durch ein Lesegerät, welches die Überwachungs- und Übertragungseinrichtungen der Geräte ausliest.

Die Überwachungs- und Übertragungseinrichtung jedes Gerätes besteht jeweils lediglich aus einem Resonatorschaltkreis aus passiven elektrischen Bauelementen. Passive elektrische Bauelemente sind z.B. Widerstände (Impedanzen), Kondensatoren (Kapazitäten), Induktivitäten (z.B. Spulen) und/oder Piezoelemente. Die Überwachungs- und Übertragungseinrichtung enthält dabei keine aktiven Bauelemente, wie z.B. integrierte Halbleiterschaltungen (Mikrochips). Die Überwachungs- und Übertragungseinrichtung enthält insbesondere keinen RFID-Transponder oder RFID-Chip, so dass keine Gefahr besteht, dass diese gestört oder z.B. bei einer Überspannung beschädigt werden.

Der Resonatorschaltkreis ist nun derart an den zu überwachenden und in dem Gerätegehäuse angeordneten Funktionsbaustein gekoppelt, dass eine Zustandsänderung des Funktionsbausteins automatisch eine Veränderung der Resonanzfrequenz oder eine Unterbrechung des Resonatorschaltkreises bewirkt. Somit wirkt der Resonatorschaltkreis als primitiver Informationsträger für den Zustand des Funktionsbausteins, dergestalt dass die Information über den jeweiligen Zustand des Funktionsbausteins lediglich in der Resonanzfrequenz des Resonatorschaltkreises begründet liegt. Im einfachsten Fall einer überspannungsausgelösten Unterbrechung des Resonatorschaltkreises repräsentieren demnach das Vorhandensein der Resonanzfrequenz und das Nichtvorhandensein aufgrund der Unterbrechung eine 1-Bit Information über das Funktionieren oder mögliche Nichtfunktionieren des Funktionsbausteins. Diese 1-Bit-Information ist in dem Resonanzschaltkreis entsprechend elektromagnetisch abfragbar "gespeichert".

Das Lesegerät fragt nun, z.B. auf Anforderung durch den Nutzer oder regelmäßig kontaktlos die momentane Resonanzfrequenz des Resonatorschaltkreises ab und stellt ausschließlich anhand der ermittelten Resonanzfrequenz oder der Abwesenheit einer Signalantwort des Resonatorschaltkreises den momentanen Zustand des Funktionsbausteins fest und zeigt dem Nutzer den festgestellten Zustand an.

Auf die Verwendung von RFID-Transpondern wird ganz bewusst verzichtet, was den Vorteil hat, dass die Überwachungs- und Übertragungseinrichtung eine hohe elektromagnetische Verträglichkeit aufweist und überdies generell außerordentlich störungsunanfällig ist, insbesondere gegen die bei einem Überspannungsschutzgerät unvermeidbar auftretenden elektromagnetischen Impulse (EMP, insbesondere LEMP). Die abzufragende Information ist somit ausschließlich in der Resonanzfrequenz (Betrag oder Vorhandensein) des Resonatorschaltkreises "gespeichert". Außerdem ist der Einsatz der Erfindung wirtschaftlich nicht nur bei relativ teuren elektrischen Gerätschaften einsetzbar, sondern ist so kostengünstig, dass die Erfindung sogar bei sehr einfachen "Low-Cost-Produkten", z.B. bei Steckverbindern, Klemmen etc. eingesetzt werden kann.

Die in dem Resonatorschaltkreis gespeicherte und abfragbare Information ist insbesondere eine Diagnose-, Konfigurations- oder Statusinformation des Funktionsbausteins. Eine Diagnoseinformation ist z.B. die ja-nein-Information (1-bit), ob der Überspannungsschutz i) noch nicht angesprochen hat oder ii) bereits angesprochen hat und daher aus Sicherheitsgründen ausgetauscht werden sollte. Es können aber in der Resonanzfrequenz auch komplexere Informationen "codiert" und abgefragt werden, nämlich wenn die Resonanzfrequenz des Resonatorschaltkreises einstellbar ist. In diesem Fall wird jeder Resonanzfrequenz eine bestimmte Information zugeordnet.

Eine bevorzugte Ausführungsform der Erfindung betrifft, wie vorstehend erläutert, die Diagnose, lediglich ob der Funktionsbaustein noch unversehrt ist oder möglicherweise einen Schaden aufweist und ausgetauscht werden sollte. D.h. die Information ist vorzugsweise eine binäre (1-bit) Diagnoseinformation über den Funktionsbaustein. In diesem Fall weist der Resonatorschaltkreis in einem Normalzustand des Funktionsbausteins eine erste Sollresonanzfrequenz auf und in einem Fehlerzustand ist der Resonatorschaltkreis unterbrochen, so dass keine Signalantwort beim Abfragen erfolgt. Alternativ kann auch bei dieser 1-bit Information der Fehlerzustand durch eine zweite von der Sollresonanzfrequenz abweichende Resonanzfrequenz signalisiert werden.

Das Lesegerät ermittelt i) bei Übereinstimmung der beim Abfragen ermittelten Resonanzfrequenz mit der Sollresonanzfrequenz das Vorliegen des Normalzustands und ii) bei Abweichung der beim Abfragen ermittelten Resonanzfrequenz von der Sollresonanzfrequenz oder bei Abwesenheit einer Signalantwort das Vorliegen des Fehlerzustands und zeigt den ermittelten Normal- bzw. Fehlerzustand an.

Hierzu wird die Überwachungs- und Übertragungseinrichtung von dem Lesegerät dadurch ausgelesen, dass das Lesegerät ein elektromagnetisches Anregungssignal einer definierten Frequenz, insbesondere der Sollresonanzfrequenz erzeugt und den Resonatorschaltkreis hiermit zum Schwingen anregt. Das Lesegerät empfängt anschließend die Signalantwort des Resonatorschaltkreises auf die Anregung und bestimmt anhand der Signalantwort die momentane Resonanzfrequenz des Resonatorschaltkreises der Überwachungs- und Übertragungseinrichtung, um in Ansprechen auf die ermittelte Resonanzfrequenz oder das Ausbleiben einer Signalantwort den Zustand des Funktionsbausteins festzustellen.

Die Überwachungs- und Übertragungseinrichtung besteht also insbesondere lediglich aus einem elektrischen Schwingkreis, umfassend Impedanzen, Kapazitäten, Induktivitäten und/oder Piezoelementen, allesamt passive elektrische Bauelemente, die sehr unempfindlich und kostengünstig sind. Bei Vorliegen des zweiten Zustands bzw. Fehlerzustands wird der Schwingkreis entweder unterbrochen, so dass er keine Signalantwort mehr geben kann oder seine Frequenz wird durch Einwirkung auf die Impedanzen, Kapazitäten, Induktivitäten und/oder Piezoelemente verändert. Z.B. können mittels thermischer oder mechanischer Auslösung Teile der Impedanz, der Kapazität, der Induktivität und/oder von Piezoelementen von dem Schwingkreis getrennt werden, so dass sich die Resonanzfrequenz des Schwingkreises verändert.

Der Schwingkreis wird vorzugsweise durch das Lesegerät angeregt und seine Signalantwort auf die Anregung wird von dem Lesegerät empfangen. Demnach benötigt die Überwachungs- und Übertragungseinrichtung keine elektrische Energieversorgung durch das zu überwachende Gerät, ist also Energie-autark. Somit funktioniert die Überwachungs- und Übertragungseinrichtung auch noch, wenn das Gerät aufgrund eines Fehlerfalls keine Energieversorgung mehr besitzt und lässt sich für Geräte verwenden, die selbst überhaupt keine Energieversorgung besitzen.

Gemäß einer bevorzugten Ausführungsform wird die Erfindung für Überspannungsschutzgeräte verwendet. Ein Beispiel auf welches hiermit Bezug genommen wird ist die Baureihe "TRABTECH" der Anmelderin (vgl. www.phoenixcontact.de/ueberspannungsschutz). Hierbei ist der Funktionsbaustein also ein Überspannungsschutzbaustein. Für Überspannungsschutzgeräte umfasst der Resonatorschaltkreis vorzugsweise eine Sicherung. Die Sicherung ist so an den Überspannungsschutzbaustein gekoppelt, dass beim Auftreten einer Überspannung, die von dem Überspannungsschutzbaustein abgeleitet wird, in dem Gerät die Sicherung auslöst. Die Auslösung der Sicherung unterbricht den Resonatorschaltkreis oder verändert seine Resonanzfrequenz durch Einwirken auf die Impedanz, Kapazität, Induktivität und/oder Piezoelemente. Die Sicherung ist vorzugsweise eine thermische Sicherung, welche ausgelöst durch die Überspannung durchbrennt, es kann aber auch eine mechanisch auslösbare Sicherung vorgesehen sein.

Die Überspannung wird zwar durch den Überspannungsschutzbaustein sicher abgeleitet, allerdings kann nun erfindungsgemäß von außen kontaktlos mittels der elektromagnetischen Antwortschwingungen der Schwingkreise festgestellt werden, ob und welches Überspannungsschutzgerät eine Überspannung abgeleitet hat. Dieses muss zwar nicht zwingend defekt sein, aber mit der Erfindung wird ermöglicht, das Überschutzgerät aus Sicherheitsgründen auszutauschen, wenn es ausgelöst hat.

Es ist ferner vorteilhaft, den Resonatorschaltkreis und das Gerät jeweils mit zueinander komplementären Steckkontakten auszustatten, so dass die Überwachungs- und Übertragungseinrichtung lösbar mit dem Gerät verbindbar ist. Dies hat den Vorteil, dass der Nutzer durch Aufstecken der Überwachungs- und Übertragungseinrichtung an das Gerät, selbst entscheiden kann, welche Geräte mit der Erfindung ausgerüstet oder ggf. nachgerüstet werden. In diesem Fall ist es ferner vorteilhaft, wenn die thermische Sicherung in dem Gerät, genauer in dem Gehäuse des zu überwachenden Geräts angeordnet ist und beim Verbinden der Steckverbindung zwischen dem Resonatorschaltkreis und dem Gerät zu einem Teil des Resonatorschaltkreises wird. Somit wird die Sicherung beim Zusammenstecken zu einem Teil des Resonatorschaltkreises und beeinflusst dann dessen Resonanzfrequenz, solange die Sicherung intakt ist. Wenn die Sicherung durchbrennt, verändert sich die Resonanzfrequenz oder der Resonatorschaltkreis wird unterbrochen.

Zweckmäßig umfasst der Resonatorschaltkreis zwei parallel geschaltete Kondensatoren, welche mittels der thermischen Sicherung verbunden sind, wenn der Resonatorschaltkreis auf das Gerät aufgesteckt ist. Wenn die Sicherung durchbrennt, wird dadurch einer der beiden Kondensatoren aus dem Schwingkreis genommen, wodurch sich die Resonanzfrequenz des Resonatorschaltkreises verändert.

Damit das Lesegerät geräteselektiv sein kann, d.h. nur ein bestimmtes einer Mehrzahl von zu überwachenden Geräten abfragt, wird z.B. die Sende- und Empfangsreichweite so kurz gewählt, dass der Nutzer das Handgerät unmittelbar an das abzufragende Gerät heranführen muss, um die Information zu übertragen, d.h. den Schwingkreis anzuregen und das Antwortsignal zu empfangen. Allerdings lassen sich trotzdem, obwohl die Erfindung sehr einfach ist, eine Vielzahl von Geräten mit jeweils einer Überwachungs- und Übertragungseinrichtung nicht nur überwachen, sondern sogar unterscheiden. In diesem Fall wird eine kontaktlos abfragbare Gerätekennung ausschließlich durch die Sollresonanzfrequenz des Schwingkreises definiert. Mit anderen Worten weisen die mehreren Überwachungs- und Übertragungseinrichtungen der unterschiedlichen Geräte unterschiedliche Sollresonanzfrequenzen auf. Das Lesegerät kann somit verschiedene Geräte ausschließlich anhand der unterschiedlichen Sollresonanzfrequenzen unterscheiden. Hierbei ist es vorteilhaft, wenn der Nutzer die Sollresonanzfrequenz des Resonatorschaltkreises selbst einstellen kann, was z.B. mittels Dip-Schaltern erfolgt. Neben dem Handgerät kann auch ein fest installiertes Sende- und Empfangsgerät genutzt werden, soweit es im Sende- und Empfangsbereich der Geräte liegt.

Es ist allerdings nicht nur möglich, Informationen über den Fehlerzustand eines Gerätes zu übertragen, was typischerweise nur eine 1-bit-Information ist, sondern es können auch komplexere Informationen, wie z.B. Messwerte kontaktlos übertragen werden. In diesem Fall weisen die Geräte jeweils eine Messeinrichtung zur Messung einer physikalischen Messgröße und ebenfalls jeweils einen Resonatorschaltkreis auf, welcher lediglich aus passiven elektrischen Bauelementen besteht. Der Resonatorschaltkreis ist nun derart an die Messeinrichtung gekoppelt, dass der von der Messeinrichtung gemessene Wert der Messgröße die Resonanzfrequenz des Resonatorschaltkreises in vorbestimmter Weise beeinflusst, so dass die Resonanzfrequenz des Resonatorschaltkreises eine stetige Funktion des gemessenen Wertes der Messgröße ist. Somit kann einer bestimmten Resonanzfrequenz ein bestimmter Wert der Messgröße zugeordnet werden. Z.B. besitzt die Kapazität des Schwingkreises ein Dielektrikum, welches seine Dielektrizitätskonstante in Anhängigkeit des elektrischen Feldes verändert. Wird eine solche Kapazität im elektrischen Feld eines stromdurchflossenen Leiters angeordnet, beeinflusst die Stromstärke direkt die Resonanzfrequenz des Schwingkreises. Allgemein wirkt der Messwert auf zumindest ein abstimmbares Element des Schwingkreises (d.h. auf die passiven elektrischen Bauelemente wie z.B. Impedanz, Kapazität, Induktivität oder Piezoelement) ein. Das Lesegerät liest dann analog die Resonanzfrequenz des Resonatorschaltkreises bestehend aus ausschließlich passiven elektrischen Bauelementen aus und bestimmt ausschließlich anhand der ermittelten Resonanzfrequenz den gemessenen Wert der Messgröße.

Im Folgenden wird die Erfindung anhand von Ausführungsbeispielen und unter Bezugnahme auf die Figuren näher erläutert, wobei gleiche und ähnliche Elemente teilweise mit gleichen Bezugszeichen versehen sind und die Merkmale der verschiedenen Ausführungsbeispiele miteinander kombiniert werden können.

### Kurzbeschreibung der Figuren

Es zeigen:
- Fig. 1: eine schematische Darstellung eines Überspannungsschutzgeräts mit einem Resonatorschaltkreis und einem Hand-Lesegerät,
- Fig. 2: eine schematische Darstellung des Überspannungsschutzgeräts aus Fig. 1 mit einem auf einer Hutschiene montierten Lesegerät,
- Fig. 3: eine schematische Darstellung des Überspannungsschutzgeräts aus Fig. 1 mit einer Ausschnittsvergrößerung des Resonatorschaltkreises,
- Fig. 4: eine schematische der Kopplung des Resonatorschaltkreises an den Überspannungsschutzbaustein,
- Fig. 5: eine schematische Darstellung eines steckbaren Resonatorschaltkreises mit thermischer Sicherung und
- Fig. 6: eine schematische Darstellung der Übertragung eines Strom-Messwertes.

### Detaillierte Beschreibung der Erfindung

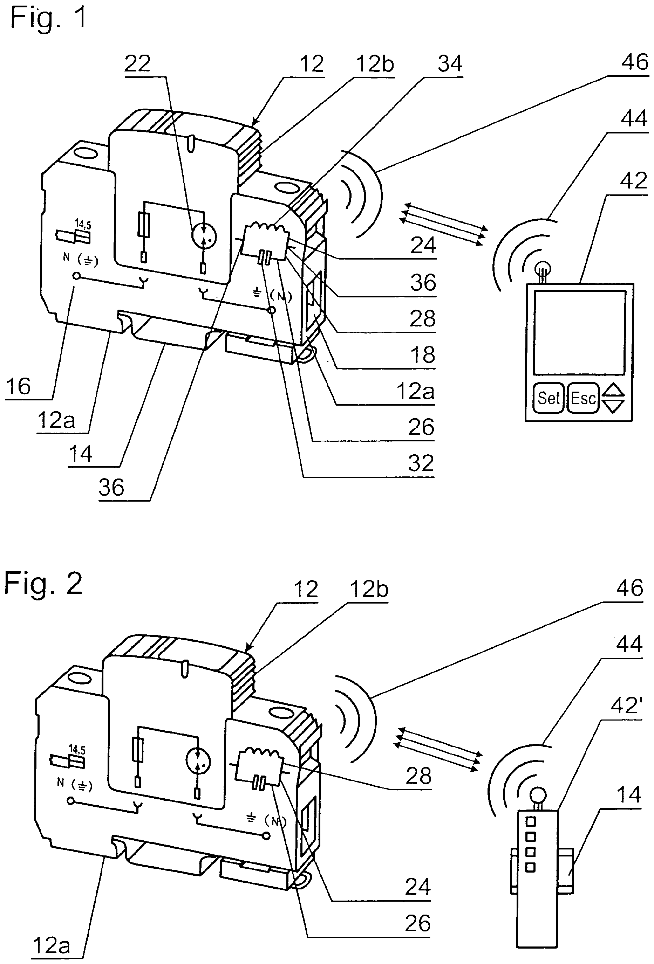

Bezug nehmend auf Fig.1 ist ein Überspannungsschutzgerät oder Überspannungsschutzmodul 12 auf einer Hutschiene 14, typischerweise in einem Schaltschrank (nicht dargestellt) montiert. Das Überspannungsschutzmodul 12 weist einen Eingang 16 und einen Ausgang 18 auf und ist zweiteilig aus zwei Teilmodulen 12a und 12b aufgebaut, wobei das Teilmodul 12a auf der Hutschiene montiert ist und den Überspannungsschutzbaustein 22 enthält. Das Teilmodul 12b ist an das Teilmodul 12a gesteckt, so dass ggf. das Teilmodul 12b ausgetauscht werden kann, ohne das Teilmodul 12a austauschen zu müssen. Das beispielhaft dargestellte Überspannungsmodul 12 gehört der TRABTECH-Reihe der Anmelderin an. Der Überspannungsschutzbaustein 22 ist in diesem Beispiel als ein Gasableiter mit einer Gasentladungsröhre realisiert und ist auf der Seite des Teilmoduls 12a symbolisiert.

Das Überspannungsschutzmodul 12 weist erfindungsgemäß einen Resonatorschaltkreis 24 als Überwachungs- und Übertragungseinrichtung 28 auf, welcher ebenfalls auf dem Modul 12 symbolisiert ist. Der Resonatorschaltkreis 24 besteht lediglich aus einem einfachen elektrischen Schwingkreis 26 mit einer Resonanzfrequenz. Der Schwingkreis besteht lediglich aus einem Kondensator 32, einer Induktivität 34 und zwei Impedanzen 36. Der Schwingkreis 26 weist in dem Auslieferungszustand eine bestimmte Sollresonanzfrequenz f₀ auf. Der Schwingkreis 26 ist nun so an den Überspannungsschutzbaustein 22 gekoppelt, dass beim Auftreten einer Überspannung der Überspannungsschutzbaustein 22 derart auf den Schwingkreis 26 einwirkt, dass dieser seine Resonanzfrequenz verändert und somit nicht mehr die Sollresonanzfrequenz f₀, sondern eine veränderte Resonanzfrequenz f' ≠ f₀ aufweist. Zum Überprüfen verwendet der Benutzer, z.B. ein Servicetechniker, ein Handlesegerät 42, welches eine elektromagnetische Anregungsschwingung 44 mit der Sollresonanzfrequenz f₀ aussendet. Mit der Anregungsschwingung 44 wird auf kurze Distanz der Schwingkreis 26 angeregt, wenn er noch schwingungsfähig ist. Anschließend empfängt das Handlesegerät 42 die Signalantwort 46 des Schwingkreises 26 und bestimmt die momentane Resonanzfrequenz f des Schwingkreises 26 anhand der Signalantwort 46.

Die Verwendung eines Handlesegerätes 42 hat den Vorteil, dass das Handlesegerät 42 vom Servicetechniker unmittelbar in kurzer Distanz zu dem Überspannungsschutzmodul 12 gebracht werden kann und somit sogar bei identischen Sollresonanzfrequenzen f₀ mehrerer Überspannungsschutzmodule 12 festgestellt werden kann, welches Überspannungsschutzmodul 12 noch mit f₀ antwortet und welches nicht, da es ausgelöst hat.

Bezug nehmend auf Fig.2 ist ein Diagnosesystem mit einem Lesegerät 42' dargestellt, welches in einem nicht dargestellten Schaltschrank auf einer Hutschiene 14 montiert ist. Bei dieser Ausführungsform sind die Geräte 12 frequenzselektiv ausgebildet, wenn mehrere zu überwachende Geräte 12 in dem Schaltschrank vorhanden sind, d.h. dass unterschiedliche Geräte 12 unterschiedliche Sollresonanzfrequenzen f₀₁, f₀₂, f₀₃ usw. aufweisen, mittels welcher sie unterscheidbar sind.

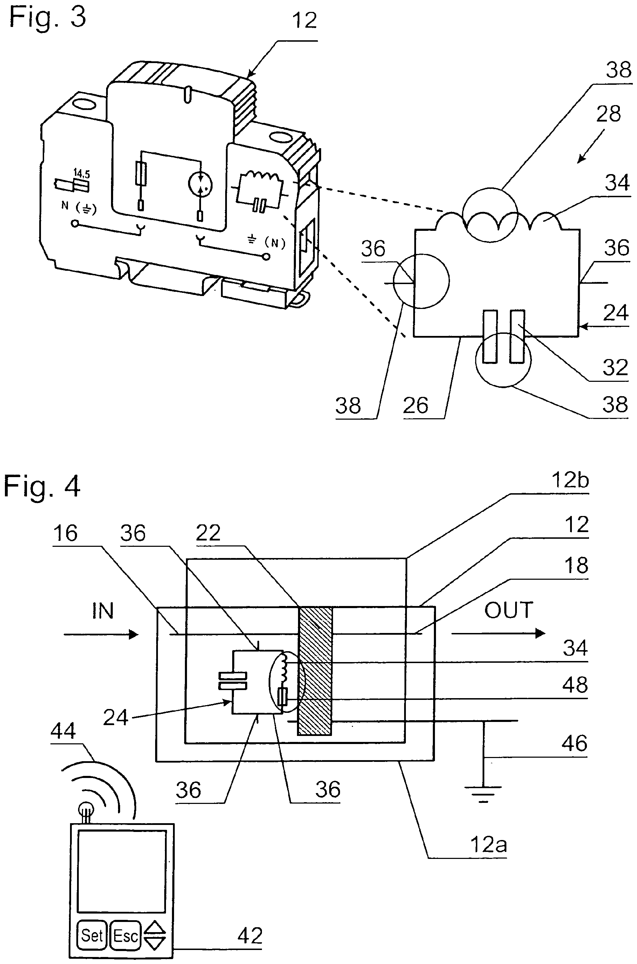

Bezug nehmend auf Fig.3 ist eine Ausschnittsvergrößerung des Schwingkreises 26 dargestellt, welcher in diesem Beispiel in dem Teilmodul 12a angeordnet ist. Der Schwingkreis 26 weist mehrere Einwirkpunkte 38 auf, an denen die Resonanzfrequenz des Schwingkreises 26 verändert werden kann, nämlich durch Veränderung der Kapazität des Kondensators 32, der Induktivität der Spule 34 und/oder der Impedanz(en) 36.

Bezug nehmend auf Fig.4 ist eine beispielhafte Ausführungsform für die Kopplung des Schwingkreises 26 an den Überspannungsschutzbaustein 22 dargestellt. Der Überspannungsschutzbaustein 22 leitet eine Überspannung gegen Erde 46 ab. Der Schwingkreis 26 umfasst eine thermische Sicherung 48 in dem Schwingkreis 26, in diesem Beispiel im Bereich der Spule 34. Wenn der Überspannungsschutzbaustein 22 eine Überspannung gegen Erde ableitet, löst die thermische Sicherung 48 mittels des in die Spule induzierten elektromagnetischen Pulses aus und unterbricht den Schwingkreis 26. Mit dem Handlesegerät 42 kann hiernach wiederum das nicht mehr Vorhandensein der Resonanzfrequenz abgefragt werden.

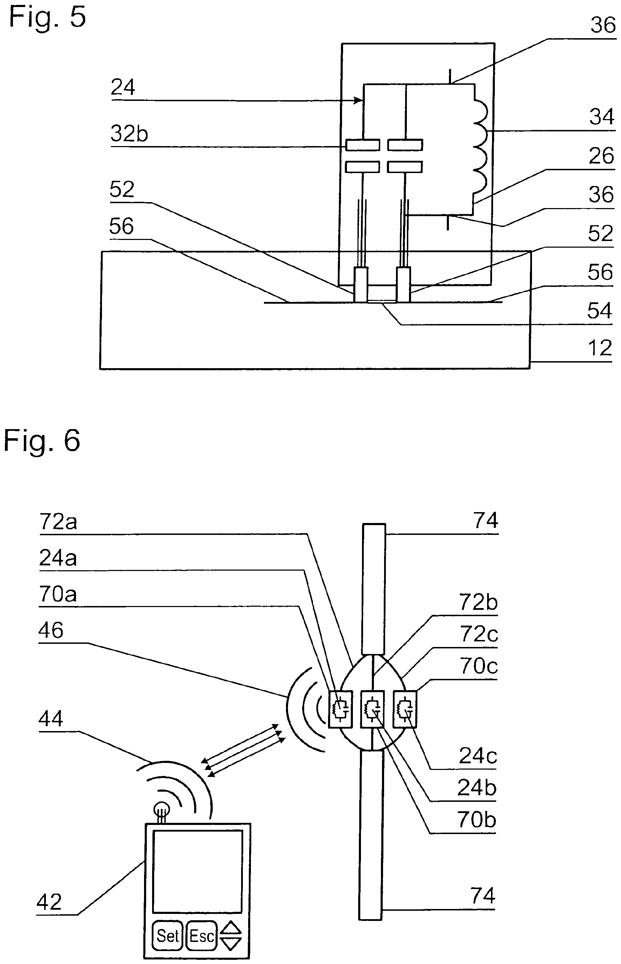

Bezug nehmend auf Fig.5 ist ein Diagnosesystem mit einem aufgesteckten Resonatorschaltkreis 24 auf dem Gerät 12 dargestellt. Der Resonatorschaltkreis 24 und das Gerät 12 weisen zueinander komplementäre Steckkontakte 52 auf. Ein Abschnitt 54 der Leiterbahn 56 des Gerätes 22 verbindet im aufgesteckten Zustand des Resonatorschaltkreises 24 zwei parallel geschaltete Kondensatoren 32a und 32b. Der Abschnitt 54 der Leiterbahn 56 ist als Sicherungselement ausgestaltet und wird bei einem Gerätedefekt, z.B. durch Überspannungseinwirkung thermisch, durchtrennt. Bei Durchtrennung des Sicherungselements 54 wird der zweite Kondensator 32b aus dem Schwingkreis 26 heraus genommen, so dass sich die Resonanzfrequenz des Schwingkreises 26 entsprechend von f₀ auf f' ≠ f₀ ändert. Alternativ kann eine kapazitive Änderung auch durch thermisches Einwirken auf das Dielektrikum erfolgen.

In einer weiteren Ausführungsform des Resonatorschaltkreises 24 weist dieser einen Energiezwischenspeicher (nicht dargestellt) auf, welcher die mittels des Lesegerätes bzw. des Abfragesignals von außen eingebrachte Energie in einem geeigneten Speicher, z.B. einem Kondensator, einer Spule oder ähnlichem zwischengespeichert wird (sog. energy harvesting). Diese Energie kann genutzt werden, um das Senden des Antwortsignals 46 zeitlich zu verlängern. Hierdurch wird eine verbesserte Signalqualität erreicht, die wiederum die Empfangselektronik in dem Lesegerät 42 vereinfacht, da weniger Resonanzstörungen im Empfangsspektrum entstehen.

Werden mehrere Geräte, z.B. Überspannungsmodule 12 in einer Umgebung, z.B. innerhalb eines Schaltschrankes verwendet, weisen die verschiedenen Geräte 12 in dem Schaltschrank Schwingkreise 26 mit jeweils unterschiedlicher Sollresonanzfrequenz f₀₁, f₀₂, f₀₃ usw. auf. Hiermit kann das Lesegerät 42 die Signalantwort 46 eindeutig einem bestimmten Gerät 12 zuordnen. Im einfachsten Fall werden alle Sollresonanzfrequenzen f₀₁, f₀₂, f₀₃ usw. abgefragt und das Lesegerät 42 zeigt diejenigen Geräte 12 an, welche mit der zugehörigen Sollresonanzfrequenz geantwortet haben, demnach also funktionsfähig sind und/oder zeigt diejenigen Geräte 12 an, welche keine Signalantwort gegeben haben und somit ggf. fehlerhaft sind und ausgetauscht werden sollen.

Die Geräte 12 können entweder werkseitig durch fixe Auslieferung oder abhängig von einer Fertigungseinstellung, z. B. Typen-, Artikel- oder Seriennummer ausgeführt werden. D.h. die Sollresonanzfrequenz f₀ ist entweder werksseitig vorgegeben oder die Sollresonanzfrequenz der Resonatorschaltkreise 24 ist projektierbar ausgeführt. Projektierbare Geräte 12 können z.B. mechanisch codiert werden, z.B. mit Schaltern oder durch das Abbrechen von Platinenabschnitten oder durch Druck-, Widerstands-, Dielektrizitäts- und/oder Induktivitätsänderung. Die Veränderung der Sollresonanzfrequenz kann aber auch durch eine Parametrierungsoberfläche, z.B. eine Software mit Geräteanbindung über ein Netzwerk erfolgen, so dass der Benutzer den jeweiligen Schwingkreis 26 selbst abstimmen kann.

Mögliche Anwendungen für die Erfindung sind neben dem vorstehend beispielhaft erläuterten Überspannungsschutz auch Reihenklemmen, Messklemmen oder Messstecker, z.B. jeweils mit einer Statusdiagnose des verbundenen Signals. Bei einer Messklemme oder einem Messstecker können ferner elektrische Messgrößen, wie Strom oder Spannung und/oder physikalische Messgrößen wie Temperatur etc. gemessen und mittels der Signalantwort 46 mit der Resonanzfrequenz des Schwingkreises an das Lesegerät 42 übertragen werden, wie nachfolgend erläutert wird.

Bezug nehmend auf Fig.6 sind z.B. drei elektrische Messklemmen 70a, 70b, 70c in eine Verdrahtung 74 eingebaut. Jede der Messklemmen 70a, 70b, 70c verbindet einen Leiter 72a, 72b, 72c der Verdrahtung 74 und weist jeweils einen erfindungsgemäßen Resonatorschaltkreis 24a, 24b, 24c auf, wobei deren Resonanzfrequenzen f₁, f₂, f₃ stufenlos abstimmbar sind. Die Frequenzbereiche F₁, F₂, F₃ der Resonanzfrequenzen f₁, f₂, f₃ der Resonatorschaltkreise 24a, 24b, 24c der drei Messklemmen 70a, 70b, 70c sind nicht überlappend gewählt, so dass das Handbediengerät 42 anhand der jeweiligen Resonanzfrequenz f₁, f₂, f₃ die drei Resonatorschaltkreise 24a, 24b, 24c unterscheiden kann. An den Messklemme 70a, 70b, 70c erfolgt eine Spannungsmessung ohne Referenzspannung durch Ausnutzung nichtlinearer Effekte in dem elektrischen Feld, welches durch den Speisestrom erzeugt wird. Die Kondensatoren der Schwingkreise 26a, 26b, 26c weisen jeweils ein Dielektrikum aus einem Material auf, dessen Dielektrizitätszahl *ε* von der elektrischen Feldstärke abhängt, so dass die Kondensatoren jeweils eine von dem Strom abhängige Kapazität aufweisen. Diese stromabhängige Kapazität wiederum führt zu einer stromabhängigen Resonanzfrequenz f(I) der Schwingkreise 26a, 26b, 26c. Somit kann das Lesegerät 42 durch Messen der jeweiligen Resonanzfrequenz f₁(I), f₂(I), f₃(I) der Schwingkreise 26a, 26b, 26c in jeder der Messklemmen 70a, 70b, 70c unabhängig voneinander den Stromwert abfragen und den jeweiligen Messwert der zugehörigen Messklemme zuordnen.

Zusammenfassend kann das zu überwachende Gerät die Frequenz des Resonatorschaltkreises in vorbestimmter Art und Weise, z.B. mittels Temperatur-, Größen-, Medien- oder Druckänderung oder über Schaltelemente/Federspannung ändern. Der Resonatorschaltkreis kann Piezo-Elemente, Spulen, Kondensatoren oder elektrische wirkende Dielektriken enthalten. Diese bilden einen Schwingkreis und enthalten mindestens ein Schwingkreiselement, welches von Außen beeinflussbar ist. In einem einfachen Fall kann ein Schwingkreiselement von dem Gerät aus dem Schwingkreis herausgenommen oder kurz geschlossen werden. Der Resonatorschaltkreis erzeugt somit verschiedene Antwortfrequenzen, die Diagnose-, Konfigurations- oder Statusinformationen entsprechen. Als Antwortsignal gibt der Resonatorschaltkreis seine eingeprägte Sollresonanzfrequenz oder die veränderte Frequenz zurück. Über das Lesegerät des Servicetechnikers wird die zurückgesendete Frequenz empfangen, ausgewertet und der weiteren Verarbeitung zugängig gemacht, z.B. als Diagnoseanzeige.

Es ist dem Fachmann ersichtlich, dass die vorstehend beschriebenen Ausführungsformen beispielhaft zu verstehen sind, und die Erfindung nicht auf diese beschränkt ist, sondern in vielfältiger Weise variiert werden kann, ohne die Erfindung zu verlassen. Ferner ist ersichtlich, dass die Merkmale unabhängig davon, ob sie in der Beschreibung, den Ansprüchen, den Figuren oder anderweitig offenbart sind auch einzeln wesentliche Bestandteile der Erfindung definieren, selbst wenn sie zusammen mit anderen Merkmalen gemeinsam beschrieben sind. Insbesondere sind die Merkmale des Kontroll- oder Diagnosesystems und des Systems zur Übertragung von Messdaten sowie die System- und Verfahrensmerkmale untereinander kombinierbar.

## Patentansprüche

1. Zustandskontroll- oder Diagnosesystem zum kontaktlosen Auslesen einer Überwachungs- und Übertragungseinrichtung (28) mittels eines Lesegerätes (42),
umfassend zumindest ein Gerät (12) mit jeweils einer Überwachungs- und Übertragungseinrichtung (28) zum Überwachen eines Funktionsbausteins (22) in dem jeweiligen Gerät (12) und zum Übertragen einer Information über den momentanen Zustand des Funktionsbausteins (22),
umfassend ferner das Lesegerät (42) zum kontaktlosen Auslesen der Überwachungs- und Übertragungseinrichtungen (28),
wobei die Überwachungs- und Übertragungseinrichtungen (28) jeweils lediglich aus einem Resonatorschaltkreis (24) aus passiven elektrischen Bauelementen (32, 34, 36) bestehen,
**dadurch gekennzeichnet,**
**dass** der Resonatorschaltkreis (24) eine Sicherung (48,54) umfasst und die Sicherung (48, 54) an den Funktionsbaustein gekoppelt ist, dergestalt dass beim Auftreten einer Überspannung in dem Gerät (12) die Sicherung (48, 54) auslöst, wobei vermittels der Auslösung der Resonatorschaltkreis (24) unterbrochen oder seine Resonanzfrequenz (f) verändert wird, so dass der Resonatorschaltkreis (24) als Informationsträger für den Zustand des Funktionsbausteins (22) wirkt, dergestalt dass die Information über den jeweiligen Zustand des Funktionsbausteins (22) lediglich in der Resonanzfrequenz (f) des Resonatorschaltkreises (24) begründet liegt und
das Lesegerät (42) die momentane Resonanzfrequenz des Resonatorschaltkreises (24) abfragt und anhand der ermittelten Resonanzfrequenz oder anhand der Abwesenheit einer Signalantwort (46) des Resonatorschaltkreises (24) den momentanen Zustand des Funktionsbausteins (22) feststellt.

2. Zustandskontroll- oder Diagnosesystem nach Anspruch 1, wobei die Information eine Diagnose-, Konfigurations- oder Statusinformation des Funktionsbausteins ist.

3. Zustandskontroll- oder Diagnosesystem nach Anspruch 2, wobei die Information eine Diagnoseinformation über den Funktionsbaustein ist und der Resonatorschaltkreis in einem Normalzustand des Funktionsbausteins eine erste Sollresonanzfrequenz (f₀) aufweist und in einem Fehlerzustand eine zweite von der Sollresonanzfrequenz abweichende Resonanzfrequenz (f') aufweist oder unterbrochen ist, und das Lesegerät
i) bei Übereinstimmung der beim Abfragen ermittelten Resonanzfrequenz mit der Sollresonanzfrequenz das Vorliegen des Normalzustands und
ii) bei Abweichung der beim Abfragen ermittelten Resonanzfrequenz von der Sollresonanzfrequenz oder bei Abwesenheit einer Signalantwort das Vorliegen des Fehlerzustands feststellt.

4. Zustandskontroll- oder Diagnosesystem nach einem der vorstehenden Ansprüche, wobei die Überwachungs- und Übertragungseinrichtung (28) von dem Lesegerät (42) dadurch ausgelesen wird, dass das Lesegerät (42) den Resonatorschaltkreis (24) mittels eines elektromagnetischen Anregungssignals (44) zum Schwingen anregt und anhand der Signalantwort (46) die momentane Resonanzfrequenz des Resonatorschaltkreises (24) der Überwachungs- und Übertragungseinrichtung bestimmt, um in Ansprechen auf die ermittelte Resonanzfrequenz oder das Ausbleiben einer Signalantwort (46) den Zustand des Funktionsbausteins (22) festzustellen.

5. Zustandskontroll- oder Diagnosesystem nach einem der vorstehenden Ansprüche, wobei die Überwachungs- und Übertragungseinrichtung (28) lediglich aus einem elektrischen Schwingkreis (26), aus Impedanzen (36), Kondensatoren (32), Induktivitäten (34) und/oder Piezoelementen besteht.

6. Zustandskontroll- oder Diagnosesystem nach Anspruch 5, wobei bei Vorliegen des Fehlerzustands der Schwingkreis (26) unterbrochen oder dessen Frequenz durch Einwirkung auf die Impedanzen (36), Kapazitäten (32), Induktivitäten (34) und/oder Piezoelemente des Schwingkreises (26) verändert wird.

7. Zustandskontroll- oder Diagnosesystem nach einem der vorstehenden Ansprüche, wobei die Überwachungs- und Übertragungseinrichtung (28) Energie-autark ist und keine elektrische Versorgung von Seiten des zu überwachenden Geräts (12) aufweist.

8. Zustandskontroll- oder Diagnosesystem nach einem der vorstehenden Ansprüche, wobei der Funktionsbaustein ein Überspannungsschutzbaustein (22) ist.

9. Zustandskontroll- oder Diagnosesystem nach einem der vorstehenden Ansprüche, wobei der Resonatorschaltkreis (24) und das Gerät (12) komplementäre Steckkontakte (52) aufweisen, so dass die Überwachungs- und Übertragungseinrichtung (28) lösbar mit dem Gerät (12) verbindbar ist.

10. Zustandskontroll- oder Diagnosesystem nach Anspruch 9, wobei die Sicherung (48, 54) eine thermische Sicherung (54) umfasst, welche in dem Gerät (12) angeordnet ist und beim Verbinden der Steckverbindung (52) zwischen dem Resonatorschaltkreis (24) und dem Gerät (12) zu einem Teil des Resonatorschaltkreises (24) wird, so dass die Sicherung (54) die Resonanzfrequenz des Resonatorschaltkreises (24) beeinflusst, wenn die Sicherung (54) intakt ist und die Sicherung (54) in dem zusammen gesteckten Zustand die Resonanzfrequenz (f) des Resonatorschaltkreises (24) verändert, wenn die Sicherung (54) durchbrennt.

11. Zustandskontroll- oder Diagnosesystem nach Anspruch 10, wobei der Resonatorschaltkreis (24) zwei parallel geschaltete Kondensatoren (32a, 32b) umfasst, welche mittels der thermischen Sicherung (54) verbunden sind, wenn der Resonatorschaltkreis (24) auf das Gerät (12) aufgesteckt ist und wobei einer der beiden Kondensatoren (32a, 32b) aus dem Resonatorschaltkreis (24) genommen wird, wenn die thermische Sicherung (54) durchbrennt, wodurch sich die Resonanzfrequenz (f) des Resonatorschaltkreises (24) verändert.

12. Zustandskontroll- oder Diagnosesystem nach einem der vorstehenden Ansprüche, umfassend eine Vielzahl von Geräten (12) mit jeweils einer Überwachungs- und Übertragungseinrichtung (28), wobei die Überwachungs- und Übertragungseinrichtungen (28) der Geräte unterschiedliche Sollresonanzfrequenzen (f₀₁, f₀₂, f₀₃) aufweisen und das Lesegerät (42) die verschiedenen Geräte (12) anhand der unterschiedlichen Sollresonanzfrequenzen (f₀₁, f₀₂, f₀₃) unterscheiden kann.

13. Zustandskontroll- oder Diagnosesystem nach Anspruch 12, wobei die Sollresonanzfrequenz (f₀) des Resonatorschaltkreises (24) vom Benutzer einstellbar ist.

14. Gerät (12) mit einem Funktionsbaustein (22) und einer Überwachungs- und Übertragungseinrichtung (28) zum Überwachen des Funktionsbausteins (22) und zum Übertragen einer Information über den momentanen Zustand des Funktionsbausteins (22),
wobei die Überwachungs- und Übertragungseinrichtung (28) lediglich aus einem Resonatorschaltkreis (24) aus passiven elektrischen Bauelementen (32, 34, 36) besteht,
**dadurch gekennzeichnet, dass** der Resonatorschaltkreis (24) eine Sicherung (48,54) umfasst und die Sicherung (48, 54) an den Funktionsbaustein (22) gekoppelt ist, dergestalt dass beim Auftreten einer Überspannung die Sicherung (48, 54) auslöst, wobei vermittels der Auslösung der Resonatorschaltkreis (24) unterbrochen oder seine Resonanzfrequenz (f) verändert wird, so dass der Resonatorschaltkreis (24) als Informationsträger für den Zustand des Funktionsbausteins (22) wirkt, dergestalt dass die Information über den jeweiligen Zustand des Funktionsbausteins (22) lediglich in der Resonanzfrequenz (f) des Resonatorschaltkreises (24) begründet liegt und die momentane Resonanzfrequenz des Resonatorschaltkreises (24) mittels eines Lesegerätes (42) abfragbar ist, um anhand der ermittelten Resonanzfrequenz oder anhand der Abwesenheit einer Signalantwort (46) des Resonatorschaltkreises (24) den momentanen Zustand des Funktionsbausteins (22) festzustellen.

15. Verfahren zur Zustandskontrolle oder Diagnose von Geräten, wobei die Geräte (12) jeweils einen zu überwachenden Funktionsbaustein (22) und eine Überwachungs- und Übertragungseinrichtung (28) umfassen, um eine Information über den Funktionsbaustein (22) zu speichern und abfragen zu können, wobei die Überwachungs- und Übertragungseinrichtung (28) lediglich aus einem Resonatorschaltkreis aus passiven elektrischen Bauelementen (32, 34, 36) besteht,
wobei der Resonanzfrequenz (f) des Resonatorschaltkreises (24) ein Funktionszustand zugeordnet wird,
wobei der Resonatorschaltkreis (24) eine Sicherung (48, 54) umfasst und die Sicherung (48, 54) an den Funktionsbaustein gekoppelt ist, dergestalt dass beim Auftreten einer Überspannung in dem Gerät (12) die Sicherung (48, 54) auslöst, wobei vermittels der Auslösung der Resonatorschaltkreis (24) unterbrochen oder seine Resonanzfrequenz (f) verändert wird,
wobei der Resonatorschaltkreis (24) von einem Lesegerät (42) elektromagnetisch angeregt wird und das Lesegerät (42) anhand der Signalantwort (46) des Resonatorschaltkreises (24) dessen momentane Resonanzfrequenz ermittelt und
wobei das Lesegerät (42) den Funktionszustand des Funktionsbausteins (22) anhand der ermittelten Resonanzfrequenz des Resonatorschaltkreises (24) bzw. des Fehlens einer Signalantwort (46) des Resonatorschaltkreises (24) feststellt.

## Claims

1. A state monitoring or diagnostics system for contactless reading of a monitoring and transmission device (28) by means of a reading device (42),
comprising at least one device (12) each having a monitoring and transmission device (28) for monitoring a functional unit (22) in the respective device (12) and for transmitting an information about the momentary state of the functional unit (22);
further comprising the reading device (42) for contactless reading of the monitoring and transmission devices (28);
wherein the monitoring and transmission devices each consist merely of a resonator circuit (24) of passive electrical components (32, 34, 36);
**characterized in that**
the resonator circuit (24) comprises a fuse (48, 54), and that the fuse (48, 54) is coupled to the functional unit such that upon occurrence of an overvoltage in the device (12) the fuse (48, 54) trips, which tripping interrupts the resonator circuit (24) or alters the resonance frequency (f) thereof, so that the resonator circuit (24) functions as an information carrier for the state of the functional unit (22), so that the information about the respective state of the functional unit (22) is merely represented by the resonance frequency (f) of the resonator circuit (24); and
the reading device (42) retrieves the momentary resonance frequency of the resonator circuit (24) and determines the momentary state of the functional unit (22) on the basis of the determined resonance frequency or on the basis of the absence of a signal response (46) from the resonator circuit (24).

2. The state monitoring or diagnostics system according to claim 1, wherein the information is a diagnostic, configuration, or status information of the functional unit.

3. The state monitoring or diagnostics system according to claim 2, wherein the information is a diagnostic information about the functional unit, and wherein in a nominal state of the functional unit the resonator circuit has a first nominal resonance frequency (f₀) and in a faulty state has a second resonance frequency (f') deviating from the nominal resonance frequency, or is interrupted; and wherein the reading device determines
i) the presence of the nominal state if the resonance frequency determined upon retrieval matches with the nominal resonance frequency; and
ii) the presence of the faulty state if the resonance frequency determined upon retrieval deviates from the nominal resonance frequency or in the case of absence of a signal response.

4. The state monitoring or diagnostics system according to any one of the preceding claims, wherein the reading of the monitoring and transmission device by the reading device (42) is effected by the reading device (42) causing the resonator circuit (24) to oscillate, by means of an electromagnetic excitation signal (44), and determining the momentary resonance frequency of the resonator circuit (24) of the monitoring and transmission device on the basis of the signal response (46), in order to determine the state of the functional unit (22) in response to the determined resonance frequency or the absence of a signal response (46).

5. The state monitoring or diagnostics system according to any one of the preceding claims, wherein the monitoring and transmission device (28) consists merely of an electric resonant circuit (26), impedances (36), capacitors (32), inductances (34), and/or piezoelectric elements.

6. The state monitoring or diagnostics system according to claim 5, wherein in the case of the faulty state, the resonant circuit (26) is interrupted or the frequency thereof is altered by effects on the impedances (36), capacitances (32), inductances (34), and/or piezoelectric elements of the resonant circuit (26).

7. The state monitoring or diagnostics system according to any one of the preceding claims, wherein the monitoring and transmission device (28) is energy autonomous and has no power supply from the device (12) to be monitored.

8. The state monitoring or diagnostics system according to any one of the preceding claims, wherein the functional unit is an overvoltage protection unit (22).

9. The state monitoring or diagnostics system according to any one of the preceding claims, wherein the resonator circuit (24) and the device (12) have complementary plug-in connectors (52) so that the monitoring and transmission device (28) can be detachably connected to the device (12).

10. The state monitoring or diagnostics system according to claim 9, wherein the fuse (48, 54) comprises a thermal fuse (54) which is arranged in the device (12) and which becomes part of the resonator circuit (24) when the plug-in connection (52) between the resonator (24) and the device (12) is connected, so that the fuse (54) influences the resonance frequency (f) of the resonator circuit (24) when the fuse (54) is intact, and so that in the plugged-in state the fuse (54) alters the resonance frequency (f) of the resonator circuit (24) when the fuse (54) burns through.

11. The state monitoring or diagnostics system according to claim 10, wherein the resonator circuit (24) comprises two capacitors (32a, 32b) connected in parallel, which are connected by means of the thermal fuse (54) when the resonator circuit (24) is plugged-in to the device (12), and wherein one of the two capacitors (32a, 32b) is removed from the resonator circuit (24) when the thermal fuse (54) burns through, thereby changing the resonance frequency (f) of the resonator circuit (24).

12. The state monitoring or diagnostics system according to any one of the preceding claims, comprising a plurality of devices (12) each having a monitoring and transmission device (28), wherein the monitoring and transmission devices (28) of the devices (12) have different nominal resonance frequencies (f₀₁, f₀₂, f₀₃), and wherein the reading device (42) is capable of differentiating the different devices (12) on the basis of the different nominal resonance frequencies (f₀₁, f₀₂, f₀₃).

13. The state monitoring or diagnostics system according to claim 12, wherein the nominal resonance frequency (f₀) of the resonator circuit (24) is adjustable by the user.

14. A device (12) comprising a functional unit (22) and a monitoring and transmission device (28) for monitoring the functional unit (22) and for transmitting information about the momentary state of the functional unit (22);
wherein the monitoring and transmission device (28) merely consists of a resonator circuit (24) of passive electrical components (32, 34, 36);
**characterized in that**
the resonator circuit (24) comprises a fuse (48, 54), which fuse (48, 54) is coupled to the functional unit (22) in such a way that upon occurrence of an overvoltage the fuse (48,54) trips, which tripping interrupts the resonator circuit (24) or alters the resonance frequency (f) thereof, so that the resonator circuit (24) functions as an information carrier for the state of the functional unit (22), so that the information about the respective state of the functional unit (22) is merely represented by the resonance frequency (f) of the resonator circuit (24) and the momentary resonance frequency of the resonator circuit (24) can be retrieved using a reading device (42) for determining the momentary state of the functional unit (22) on the basis of the determined resonance frequency or on the basis of the absence of a signal response (46) from the resonator circuit (24).

15. A method for state monitoring or diagnostics of devices, wherein the devices (12) each comprise a functional unit (22) to be monitored and a monitoring and transmission device (28), in order to be able to store and retrieve an information about the functional unit (22), wherein the monitoring and transmission device (28) merely consists of a resonator circuit of passive electrical components (32, 34, 36);
wherein the resonance frequency (f) of the resonator circuit (24) is associated with a functional state;
wherein the resonator circuit (24) comprises a fuse (48, 54), and wherein the fuse (48, 54) is coupled to the functional unit such that upon occurrence of an overvoltage in the device (12) the fuse (48, 54) trips, which tripping interrupts the resonator circuit (24) or alters the resonance frequency (f) thereof;
wherein the resonator circuit (24) is excited electromagnetically by a reading device (42) and the reading device (42) determines the momentary resonance frequency of the resonator circuit (24) on the basis of the signal response (46) thereof, and
wherein the reading device (42) determines the functional state of the functional unit (22) on the basis of the determined resonance frequency of the resonator circuit (24) or on the basis of the absence of a signal response (46) from the resonator circuit (24).

## Revendications

1. Système de contrôle d'état ou de diagnostic destiné à la lecture sans contact d'un dispositif de surveillance et de transmission (28) au moyen d'un appareil de lecture (42),
comprenant au moins un appareil (12) comportant chacun un dispositif de surveillance et de transmission (28) destiné à surveiller un module fonctionnel (22) dans l'appareil (12) respectif et à transmettre une information concernant l'état momentané du module fonctionnel (22),
comprenant en outre l'appareil de lecture (42) pour la lecture sans contact des dispositifs de surveillance et de transmission (28),
les dispositifs de surveillance et de transmission (28) étant constitués chacun simplement d'un circuit résonnant (24) formé de composants (32, 34, 36) électriques passifs,
**caractérisé en ce que**
le circuit résonnant (24) comprend un coupe-circuit (48, 54) et le coupe-circuit (48, 54) est couplé au module fonctionnel, de telle sorte que lors de l'apparition d'une surtension dans l'appareil (12), le coupe-circuit (48, 54) se déclenche, le déclenchement ayant pour effet d'interrompre le circuit résonnant (24) ou de modifier sa fréquence de résonance (f), de sorte que le circuit résonnant (24) agit comme support d'information pour l'état du module fonctionnel (22), de telle façon que l'information sur l'état respectif du module fonctionnel (22) est fondée uniquement sur la fréquence de résonance (f) du circuit résonnant (24), et
l'appareil de lecture (42) demande la fréquence de résonance momentanée du circuit résonnant (24) et constate l'état momentané du module fonctionnel (22), sur la base de la fréquence de résonance déterminée ou sur la base de l'absence d'une réponse de signal (46) du circuit résonnant (24).

2. Système de contrôle d'état ou de diagnostic selon la revendication 1, dans lequel l'information est une information de diagnostic, de configuration ou d'état du module fonctionnel.

3. Système de contrôle d'état ou de diagnostic selon la revendication 2, dans lequel l'information est une information de diagnostic sur le module fonctionnel, et le circuit résonnant, dans un état normal du module fonctionnel, présente une première fréquence de résonance de consigne (f₀) et, dans un état de défaut, présente une deuxième fréquence de résonance (f'), différente de la fréquence de résonance de consigne, ou est interrompu, et l'appareil de lecture
i) en cas de coïncidence de la fréquence de résonance, déterminée lors de l'interrogation, avec la fréquence de résonance de consigne, constate la présence de l'état normal, et
ii) en cas d'écart de la fréquence de résonance, déterminée lors de l'interrogation, par rapport à la fréquence de résonance de consigne ou en cas d'absence d'une réponse de signal, constate la présence de l'état de défaut.

4. Système de contrôle d'état ou de diagnostic selon l'une des revendications précédentes, dans lequel le dispositif de surveillance et de transmission (28) est lu par l'appareil de lecture (42) par le fait que l'appareil de lecture (42) excite des oscillations dans le circuit résonnant (24), au moyen d'un signal d'excitation (44) électromagnétique, et détermine la fréquence de résonance momentanée du circuit résonnant (24) du dispositif de surveillance et de transmission, à l'aide de la réponse de signal (46), afin de constater l'état du module fonctionnel (22), en réponse à la fréquence de résonance déterminée ou à l'absence d'une réponse de signal (46).

5. Système de contrôle d'état ou de diagnostic selon l'une des revendications précédentes, dans lequel le dispositif de surveillance et de transmission (28) est constitué seulement d'un circuit oscillant (26) électrique, d'impédances (36), de condensateurs (32), d'inductances (34) et/ou d'éléments piézoélectriques.

6. Système de contrôle d'état ou de diagnostic selon la revendication 5, dans lequel, en cas d'état de défaut, le circuit oscillant (26) est interrompu ou sa fréquence est modifiée en agissant sur les impédances (36), les capacités (32), les inductances (34) et/ou les éléments piézoélectriques du circuit oscillant (26).

7. Système de contrôle d'état ou de diagnostic selon l'une des revendications précédentes, dans lequel le dispositif de surveillance et de transmission (28) est autosuffisant sur le plan énergétique et ne présente pas d'alimentation électrique du côté de l'appareil (12) à surveiller.

8. Système de contrôle d'état ou de diagnostic selon l'une des revendications précédentes, dans lequel le module fonctionnel est un module de protection contre les surtensions (22).

9. Système de contrôle d'état ou de diagnostic selon l'une des revendications précédentes, dans lequel le circuit résonnant (24) et l'appareil (12) présentent des contacts enfichables (52) complémentaires, de sorte que le dispositif de surveillance et de transmission (28) peut être relié de façon amovible à l'appareil (12).

10. Système de contrôle d'état ou de diagnostic selon la revendication 9, dans lequel le coupe-circuit (48, 54) comprend un coupe-circuit thermique (54) qui est disposé dans l'appareil (12) et, lors de l'établissement de la connexion enfichable (52) entre le circuit résonnant (24) et l'appareil (12), devient une partie du circuit résonnant (24), de sorte que le coupe-circuit (54) influe sur la fréquence de résonance du circuit résonnant (24) lorsque le coupe-circuit est intact, et le coupe-circuit (54), à l'état enfiché, modifie la fréquence de résonance (f) du circuit résonnant (24) lorsque le coupe-circuit (54) est grillé.

11. Système de contrôle d'état ou de diagnostic selon la revendication 10, dans lequel le circuit résonnant (24) comprend deux condensateurs (32a, 32b) montés en parallèle, qui sont reliés au moyen du coupe-circuit thermique (54) lorsque le circuit résonnant (24) est enfiché sur l'appareil (12), et dans lequel l'un des deux condensateurs (32a, 32b) est retiré du circuit résonnant (24) lorsque le coupe-circuit thermique (54) est grillé, ce qui a pour effet de modifier la fréquence de résonance (f) du circuit résonnant (24).

12. Système de contrôle d'état ou de diagnostic selon l'une des revendications précédentes, comprenant une pluralité d'appareils (12) comportant chacun un dispositif de surveillance et de transmission (28), les dispositifs de surveillance et de transmission (28) des appareils présentant des fréquences de résonance de consigne (f₀₁, f₀₂, f₀₃) différentes et l'appareil de lecture (42) peut distinguer les différents appareils (12) à l'aide des fréquences de résonance de consigne (f₀₁, f₀₂, f₀₃) différentes.

13. Système de contrôle d'état ou de diagnostic selon la revendication 12, dans lequel la fréquence de résonance de consigne (fo) du circuit résonnant (24) peut être réglée par l'utilisateur.

14. Appareil (12) comprenant un module fonctionnel (22) et un dispositif de surveillance et de transmission (28) destiné à surveiller le module fonctionnel (22) et à transmettre une information concernant l'état momentané du module fonctionnel (22),
dans lequel le dispositif de surveillance et de transmission (28) est constitué simplement d'un circuit résonnant (24) formé de composants (32, 34, 36) électriques passifs,
**caractérisé en ce que**
le circuit résonnant (24) comprend un coupe-circuit (48, 54) et le coupe-circuit (48, 54) est couplé au module fonctionnel (22), de telle sorte que lors de l'apparition d'une surtension, le coupe-circuit (48, 54) se déclenche, le déclenchement ayant pour effet d'interrompre le circuit résonnant (24) ou de modifier sa fréquence de résonance (f), de sorte que le circuit résonnant (24) agit comme support d'information pour l'état du module fonctionnel (22), de telle façon que l'information sur l'état respectif du module fonctionnel (22) est fondée uniquement sur la fréquence de résonance (f) du circuit résonnant (24) et que la fréquence de résonance momentanée du circuit résonnant (24) peut être demandée au moyen d'un appareil de lecture (42), afin de constater l'état momentané du module fonctionnel (22), sur la base de la fréquence de résonance déterminée ou sur la base de l'absence d'une réponse de signal (46) du circuit résonnant (24).

15. Procédé de contrôle d'état ou de diagnostic d'appareils, sachant que les appareils (12) comportent chacun un module fonctionnel (22) à surveiller et un dispositif de surveillance et de transmission (28), afin de mémoriser et extraire une information concernant le module fonctionnel (22), le dispositif de surveillance et de transmission (28) étant constitué seulement d'un circuit résonnant formé de composants (32, 34, 36) électriques passifs,
sachant qu'un état de fonctionnement est associé à la fréquence de résonance (f) du circuit résonnant (24),
sachant que le circuit résonnant (24) comprend un coupe-circuit (48, 54) et le coupe-circuit (48, 54) est couplé au module fonctionnel, de telle sorte que lors de l'apparition d'une surtension dans l'appareil (12), le coupe-circuit (48, 54) se déclenche, le déclenchement ayant pour effet d'interrompre le circuit résonnant (24) ou de modifier sa fréquence de résonance (f),
sachant que le circuit résonnant (24) est excité sur le plan électromagnétique par un appareil de lecture (42) et l'appareil de lecture (42), sur la base de la réponse de signal (46) du circuit résonnant (24), détermine la fréquence de résonance momentanée de celui-ci, et
sachant que l'appareil de lecture (42) constate l'état de fonctionnement du module fonctionnel (22) à l'aide de la fréquence de résonance déterminée du circuit résonnant (24) ou de l'absence d'une réponse de signal (46) du circuit résonnant (24).
